Europäisches Patentamt

European Patent Office

Office européen des brevets

(11) Publication number: **0 066 675**
**B1**

(12) EUROPEAN PATENT SPECIFICATION

(45) Date of publication of patent specification: **03.07.85**

(21) Application number: **82101969.2**

(22) Date of filing: **12.03.82**

(51) Int. Cl.⁴: **H 01 L 29/60,** H 01 L 29/78,
H 01 L 21/285

(54) Processes for the fabrication of field effect transistors.

(30) Priority: **08.06.81 US 271303**

(43) Date of publication of application:
**15.12.82 Bulletin 82/50**

(45) Publication of the grant of the patent:
**03.07.85 Bulletin 85/27**

(84) Designated Contracting States:
**DE FR GB**

(56) References cited:
EP-A-0 005 181
EP-A-0 040 701
DE-A-2 729 658
GB-A-1 388 772
GB-A-2 045 525

IBM TECHNICAL DISCLOSURE BULLETIN, Vol.
24, No. 4, September 1981 New York S.P.
GAUR et al. "Performance Enhancement of
Bipolar Transistor by Emitter Depth Reduction"
pages 2157 to 2159

(73) Proprietor: **International Business Machines
Corporation
Old Orchard Road
Armonk, N.Y. 10504 (US)**

(72) Inventor: **Fowler, Alan Bicksler
3511 Kamhi Drive
Yorktown Heights New York 10598 (US)**
Inventor: **Hartstein, Allan Mark
5 Deborah Lane
Chappaqua, New York 10514 (US)**

(74) Representative: **Hobbs, Francis John
IBM United Kingdom Patent Operations
Hursley Park
Winchester, Hants, SO21 2JN (GB)**

EP 0 066 675 B1

## Description

This invention relates to field effect transistors and processes for their fabrication.

The speed or frequency response of field effect transistor type devices is limited by the transit time of the carriers (electrons or holes depending on the substrate doping) and the capacitance of the gate. Efforts in the art have been made to fabricate short channel field effect transistors in order to reduce the transit time and capacitance of the gate. For example, DE—A—2,729,658 discloses a field effect transistor comprising source and drain regions 2, 3 of one conductivity type separated by a channel region of the opposite conductivity type and a narrow (1 µm or less) control gate 9 formed over and closely adjacent to the channel region. However, the processes suggested in the prior art are somewhat complicated and not especially reliably reproducible. Exemplary techniques attempted or suggested for providing short channel FETs involve the relative etching rates of metals and silicon dioxide, overlapping gate structures, serial diffusions, and converging crystallographic plane preferential etching.

The present invention seeks to provide a simple method for providing a narrow control gate field effect transistor.

The narrow control gate is the region of the transistor which is most closely adjacent to its channel region which lies between a source region and a drain region. The maximum width of the narrow control gate is about 300 nm (3000 Å).

A process of fabricating a field effect transistor having source and drain regions of one conductivity type separated by a channel region of the opposite conductivity type, includes forming a thin gate oxide layer over said channel region and is characterised, according to the invention, by providing a recess with a vertical sidewall in said gate oxide layer, vapour depositing metal in the recess in said gate oxide at such an angle that a thicker metal deposit is formed on said vertical sidewall than on the remainder of the recess and etching away the metal in the recess so as to leave only a metal coating on the sidewall and providing an electrical connection to that metal coating in order that it can serve as a narrow control gate for the field effect transistor.

How the invention can be carried out will now be described by way of example, with reference to the accompanying drawings, in which:—

Figs. 1.1—1.6 represent cross-sections, taken along the lines 1—1 indicated in Fig. 2, of a field effect transistor at various successive stages of fabrication by a process embodying the invention.

Fig. 2 represents a plan of a field effect transistor device fabricated by a method embodying the invention.

For convenience, the discussion of the fabrication steps is directed to the use of a p-type silicon substrate and n-type carriers (electrons) with n-type source and drain regions. This results in the production of n-channel FETs. Alternatively, an n-type substrate and p-type diffused or implanted dopant impurities in the source and drain regions can be used to produce p-channel FETs.

The invention is applicable to substrates other than silicon. Also, as used herein, the terms "metallic type interconnection lines" or "high conductivity interconnection lines" refer to metal lines, such as aluminium as well as non-metallic materials (e.g. highly doped polysilicon or intermetallic silicides) which, nevertheless, can have conductivities of the magnitude generally possessed by conductive metals. Also, when reference is made to impurities of a "first type" and to impurities of a "second type", the "second type" refers to the opposite conductivity type than the "first type". That is, if the "first type" is p, then the "second type" is n. If the "first type" is n, then the "second type" is p.

Also, for convenience, the discussion of the fabrication steps refer to photolithography. However, other lithographic techniques, such as electron-beam systems, can be employed when desired. Moreover, although the discussion which follows refers to wet chemical etching, it is understood that other etching techniques, such as reactive ion etching, can be used when desired.

Although, the fabrication process is described employing the preferred material, aluminium, as the control gate, other materials can be employed to provide the control gate. In particular, the control gate can also be fabricated from refractory metals or their silicides in addition to aluminium. A refractory metal is understood within the context of the present application to be a metal which can withstand the high temperatures experienced during the fabrication without degrading to an undesired extent. Examples of some suitable refractory metals include tungsten, tantalum, hafnium, and rhodium. Examples of some suitable silicides include tungsten silicide, tantalum silicide, hafnium silicide, and rhodium silicide.

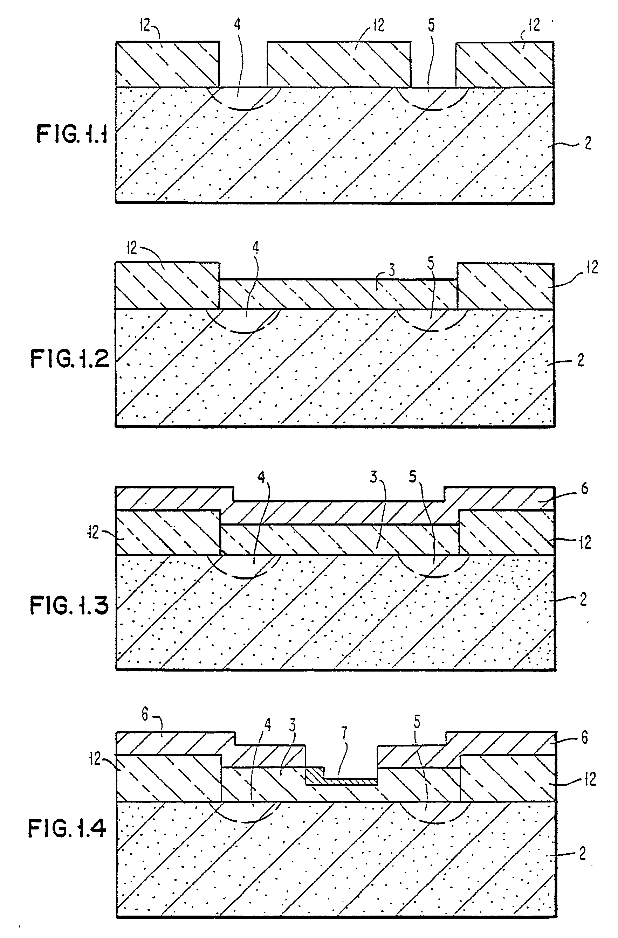

Referring to Fig. 1.1, a p-type silicon substrate 2 having any desired crystal orientation (e.g. 100) is prepared by slicing and polishing a p-type boule grown in the presence of a p-type dopant, such as boron, following conventional crystal growth techniques. Other p-type dopants for silicon include aluminium, gallium, and indium.

Field oxide isolation 12 can be fabricated by any of several known procedures including thermal oxidation of the semiconductor substrate or by well-known vacuum or chemical vapour deposition techniques. Furthermore, the field oxide may be formed above the semiconductive surface or it may be partially or fully recessed into the semiconductor substrate. An example of one such procedure is the fully recessed oxide isolation technique disclosed in U.S. Patent 3,899,363.

For the purpose of illustration of the procedure of the present invention, a non-recessed field isolation oxide will be used. The field isolation regions are generally about 400 to 1000 nm (4,000 to about 10,000 angstroms) thick. The field oxide regions 12 and the regions under which source and drain regions 4 and 5 are formed are delineated by employing a lithographic mask. The mask is of a transparent material having opaque portions in a predetermined pattern. Next, source and drain regions 4 and 5 are formed in the p-silicon substrate 2, such as by thermal diffusion or ion-implantation of an impurity of the n-type. Examples of some n-type impurities for a silicon substrate include arsenic, phosphorus, and antimony.

Using a photolithographic technique, the field oxide 12 is etched from an area where a thin gate oxide insulator layer 3 (Fig. 1.2) is to be subsequently grown.

The relatively thin gate insulator layer of silicon dioxide 3 is grown or deposited onto the silicon substrate 2. This gate insulator, which is usually about 10 to 100 nm (100 to 1,000 angstroms) thick, can be formed by thermal oxidation of the silicon surface at 1000°C in the presence of dry oxygen.

Next, a masking material 6 (Fig. 1.3) is deposited over the structure. A preferred material is aluminium which is preferably deposited by known evaporation techniques. A preselected hole is then etched into the masking layer 6 by known techniques, thereby forming a mask for subsequent etching of the oxide layer 3 which has been exposed by the removal of the masking material. For instance, the aluminium can be etched with an etchant composition containing about 1 part by volume of nitric acid, about 4 parts by volume of water, and about 20 parts by volume of phosphoric acid. Such an etch can be accomplished at room temperature with about 0.26 nm (2.6 Å) being removed per second.

Next, a recess is formed in the oxide layer 3, as illustrated in Fig. 1.4, by etching the oxide, preferably by reactive ion etching, to remove oxide not protected by the aluminium layer. The etching employed should be a directional etching procedure to produce a well-defined step in the oxide. Preferably, the amounts etched away should be about one-half of the total thickness of the oxide layer. Typical conditions of reactive ion etching include using a $CF_4$ gas at about 25 microns of pressure at a gas flow rate of about 40 standard cubic centimetres per minute and employing about 20 watts of power which is equivalent to a power density of about 0.073 watts per cm$^2$. These particular parameters provide for an etch rate of about 16 nm (160 Å) per minute.

The remaining masking layer 6 is then stripped away. For instance, in the case of aluminium, the above described etching composition can be employed.

An alternative procedure is to fully etch the $SiO_2$ down to the underlying silicon and subsequently to regrow a thin gate oxide. For instance, a 100 nm (1000 Å) gate oxide might be completely etched by this procedure and a 50 nm (500 Å) oxide regrown. This procedure would also produce the desired recess in the gate oxide layer.

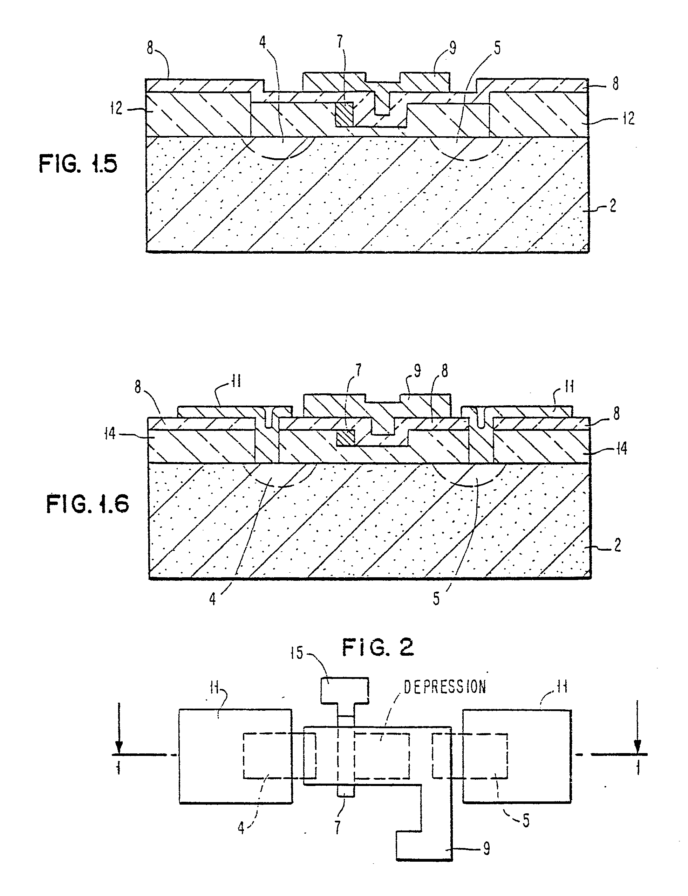

Next, a metal 15 (see Fig. 2) is deposited on the sample. The metal layer is lithographically defined to form a contact pad for the subsequent thin metal control gate to external circuitry.

Next, a metal 7 is deposited, preferably by evaporation, angularly such that a thicker metal deposit is provided adjacent one sidewall of the recess as compared to that over the horizontal surface of the oxide. The angle of evaporation should be greater than 45° from the normal to the horizontal surface of the oxide, and preferably is at least about 60°. The larger the angle, the better the process. The angle is less than 90°, and preferably as close to 90° as is possible to deposited the metal. The most preferred angle range is about 60° to about 80°. The difference between the thickness of the metal deposited on the horizontal surface of the oxide and that on the sidewall is a sine-cosine relationship. For instance, at an evaporation angle of about 80°, the ratio of the thickness of the metal deposited on the sidewall to that deposited on the horizontal surface is about 5.7 : 1. Any process for directional deposition of metal, such as vapour deposition, can be employed. Preferred metals include aluminium and gold.

In a typical application, the metal is deposited to provide a thickness of about 10 to 500 nm (100 to 5000 Å) adjacent the sidewall. It is preferred that the thickness of the metal adjacent the sidewall be equal to about the height of the sidewall. The thickness adjacent the sidewall is preferably at least twice that on the surface. In a particular embodiment, about 70 nm (700 Å) thickness of aluminium is deposited on the sidewall at an 80° angle. In such instance, about 12 nm (120 Å) thickness of aluminium is deposited on the surface.

In order to provide the thin gate, the surface aluminium coverage is then etched off, leaving a residual aluminium coating on the sidewall of the oxide. Since the aluminium is thicker adjacent the sidewall, etching of the aluminium on the vertical surfaces results in leaving an amount of aluminium which is sufficient to provide the thin gate. For instance, the device gate for the above dimensions discussed would be about 50 nm (500 Å). The gate so formed will be referred to herein as the control gate.

The etching of the aluminium can employ the particular etching parameters discussed hereinabove for the initial etch requirements. It is preferable that the etching be somewhat controlled and slow so as not to remove more than necessary from the sidewall of the structure. Typical device gate widths are up to about 300 nm (3000 Å) preferably at least about 6 nm (60 Å). Preferably, the device gate is about 10 to 100 nm (100 to about 1000 Å) wide.

Next a photoresist (not shown) is applied to the thin metallic device gate adjacent the step in the oxide layer to protect it from subsequent etching procedure which is to remove metal from the other portions of the structure whereby the metal still remains. Any known photoresist can be employed. Next, the metal remaining on other portions of the structure, such as aluminium, is removed by etching, such as using an etch composition and conditions of the type discussed hereinbefore.

Silicon oxide layer 8 (Fig. 1.5) is then deposited over the entire structure, such as by employing chemical vapour deposition. In the alternative, a plasma oxide deposition can be employed.

Next, an overlap gate 9 is delineated on top of the oxide and over the control gate by photolithographic techniques well known in the art. The overlap gate is preferably an electrically conductive metal, such as aluminium. The length and width of the overlap gate should be sufficient to overlap the source and drain regions.

In fabricating FET integrated circuits, it is necessary to connect high-electrical conductivity lines to the source, drain and control gate regions 4, 5 and 15 of the device. The electrical connections are fabricated by applying a photoresist layer to the assembly. The resist materials are exposed with ultraviolet radiation using a lithographic masking pattern, and the exposed regions of the resist are dissolved away. Next, the structure is treated to remove the portions of the oxide not protected by the resist material. For instance, the structure is immersed in a solution of buffered hydrofluoric acid to provide contact holes or vias (Fig. 1.6) through the oxide insulation layers 8 and 3 to allow electrical connection to be made to the source and drain of the FET and through the oxide insulation layer 8 to allow electrical connection to be made to the control gate. In Fig. 1.6, oxide layers 3 and 12 are shown as one layer 14 for convenience purposes. The remaining photoresist above the etched silicon dioxide is then removed by dissolving in a suitable solvent.

Next, the metallic-type high electrical conductivity interconnection line material 11, preferably a metal, is deposited and the interconnection pattern is delineated. An example of a highly conductive material commonly used for interconnections is aluminium. The high electrical conductivity material, such as aluminium, may be deposited by sputtering or, preferably, by evaporation.

Next, a photoresist layer (not shown) is applied to the assembly. The resist material is exposed with ultraviolet radiation using a predetermined mask pattern and the exposed regions of the resist are dissolved away. Then the structure is treated to remove the portions of conductive material not protected by the resist.

In operation of this short channel FET, the overlap gate is biased with a constant voltage Vo which is sufficient to invert the surface of the semiconductor (change the type of the carriers under the gate) under the overlap gate. This provides the electrical contact between the source and drain regions and the control gate region. Next, an applied voltage Vc to the control gate will control the flow of current between source and drain as in a conventional FET. Depending on the exact parameters used in fabrication (substrate doping level, oxide thickness, control gate width, etc.) and the overlap gate bias voltage Vo, the device will operate in either depletion or enhancement mode.

## Claims

1. A process of fabricating a field effect transistor having source (4) and drain (5) regions of one conductivity type separated by a channel region of the opposite conductivity type, the process including forming a thin gate oxide layer (3) over said channel region and being characterised by providing a recess with a vertical sidewall in said gate oxide layer, vapour depositing metal (7, FIG 1.4) in the recess in said gate oxide at such an angle that a thicker metal deposit is formed on said vertical sidewall than on the remainder of the recess and etching away the metal in the recess so as to leave only a metal coating (7, FIG 1.5) on the sidewall and providing an electrical connection (15) to that metal coating in order that it can serve as a narrow control gate for the field effect transistor.

2. A process as claimed in claim 1, which further includes forming an insulating layer (8) over said narrow control gate (7, FIG 1.5) and the channel region, and forming an overlap gate (9) on said insulating layer so that the overlap gate covers said narrow control gate.

3. A process as claimed in claim 1 or claim 2, in which the metal is deposited in the recess at an angle of about 80° to the vertical sidewall.

4. A process as claimed in any preceding claim, wherein the ratio of thickness of the metal adjacent to said vertical sidewall to that on the base of the recess is at least 2:1.

5. A process as claimed in claim 4, wherein the thickness of the metal deposited on the vertical sidewall is about equal to the height of the vertical sidewall.

6. A process as claimed in any preceding claim, wherein the maximum width of said narrow control gate is about 300 nm (3000 Å).

7. A process as claimed in claim 6, wherein the minimum width of said narrow control gate is at least 5 nm (50 Å).

8. A process as claimed in any of claims 1 to 5, wherein the width of said narrow control gate is about 10 to 100 nm (100 to 1000 Å).

## Revendications

1. Procédé de fabrication d'un transistor à effet de champ comportant des régions de source (4) et de drain (5) d'un type de conductivité séparées par une région de canal possédant le type de conductivité opposé, le procédé incluant la formation d'une couche d'oxyde de grille mince (3) sur ladite région de canal et étant caractérisé par l'aménagement d'un renfoncement comportant une paroi latérale verticale dans ladite couche d'oxyde de grille, le dépôt en phase vapeur d'un métal (7, figure 1.4) dans le renfoncement ménagé dans ledit oxyde de grille, sous un angle tel qu'il se forme sur ladite paroi latérale verticale un dépôt métallique plus épais que sur le reste due renfoncement, et l'élimination par attaque chimique du métal situé dans le renfoncement de manière à laisser subsister uniquement un revêtement métallique (7, figure 1.5) sur la paroi latérale, et l'établissement d'une connexion électrique (15) avec ce revêtement métallique de manière qu'il puisse servir de grille de commande étroite pour le transistor à effet de champ.

2. Procédé selon la revendication 1, qui inclut en outre la formation d'une couche isolante (8) sur ladite grille de commande étroite (7, figure 1.5) et sur la région de canal, et la formation d'une grille de recouvrement (9) sur ladite couche isolante de telle manière que la grille de recouvrement recouvre ladite grille de commande étroite.

3. Procédé selon la revendication 1 ou 2, selon lequel le métal est déposé dans le renfoncement suivant un angle d'environ 80° par rapport à la paroi latérale verticale.

4. Procédé selon l'une quelconque des revendications précédentes, selon lequel le rapport de l'épaisseur du métal au voisinage de ladite paroi latérale verticale à l'épaisseur du métal situé sur la base du renfoncement est égal au moins à 2:1.

5. Procédé selon la revendication 4, selon lequel l'épaisseur du métal déposé sur la paroi latérale verticale est approximativement égale à la hauteur de cette paroi.

6. Procédé selon l'une quelconque des revendications précédentes, selon lequel la largeur maximale de ladite grille de commande étroite est d'environ 300 nm (3000 Å).

7. Procédé selon la revendication 6, selon lequel la largeur minimale de ladite grille de commande étroite est égale au moins à 5 nm (50 Å).

8. Procédé selon l'une quelconque des revendications 1 à 5, selon lequel la largeur de ladite grille de commande étroite est comprise entre environ 10 et 100 nm (100 à 1000 Å).

**Patentansprüche**

1. Verfahren zur Herstellung eines Feldeffekttransistors mit einem Source-Bereich (4) und einem Drain-Bereich (5) des einen Leitungstyps, die durch einen Kanalbereich des entgegengesetzten Leitungstyps getrennt sind, wobei das Verfahren das Ausbilden einer dünnen Gate-Oxidschicht (3) über dem Kanalbereich umfaßt und gekennzeichnet ist durch das Vorsehen einer Ausnehmung mit einer vertikalen Seitenwand in der Gate-Oxidschicht, eine Gasphasenabscheidung von Metall (7, Fig. 1.4) in der Ausnehmung des Gate-Oxids unter einem solchen Winkel, daß auf der vertikalen Seitenwand eine dickere Metallabscheidung als auf dem übrigen Teil der Ausnehmung ausgebildet wird, und das Wegätzen des Metalls in der Ausnehmung derart, daß nur ein Metallbeschichtung (7, Fig. 1.5) auf der Seitenwand übrig bleibt, und das Vorsehen einer elektrischen Verbindung (15) zur Metallbeschichtung, damit sie als schmales Steuer-Gate für den Feldeffekttransistor dienen kann.

2. Verfahren nach Anspruch 1, welches ferner das Ausbilden einer Isolationsschicht (8) über dem schmalen Steuer-Gate (7, Fig. 1.5) und dem Kanalbereich und das Ausbilden eines Überlapp-Gate (9) auf der Isolationsschicht derart, daß das Überlapp-Gate das schmale Steuer-Gate überdeckt, beinhaltet.

3. Verfahren nach Anspruch 1 oder Anspruch 2, bei welchem das Metall in der Ausnehmung unter einem Winkel von ungefähr 80° zur vertikalen Seitenwand abgeschieden wird.

4. Verfahren nach irgendeinem vorstehenden Anspruch, bei welchem das Verhältnis der Dicke des an die vertikale Seitenwand angrenzenden Metalls zu derjenigen auf der Basisfläche der Ausnehmung wenigstens 2:1 ist.

5. Verfahren nach Anspruch 4, bei welchem die Dicke des auf der vertikalen Seitenwand abgeschiedenen Metalls ungefähr gleich der Höhe der vertikalen Seitenwand ist.

6. Verfahren nach irgendeinem vorstehenden Anspruch, bei welchem die maximale Breite des schmalen Steuer-Gate ungefähr 300 nm (3000 Å) beträgt.

7. Verfahren nach Anspruch 6, bei welchem die minimale Breite des schmalen Steuer-Gate wenigstens 5 nm (50 Å) beträgt.

8. Verfahren nach irgendeinem der Ansprüche 1 bis 5, bei welchem die Breite des schmalen Steuer-Gate ungefähr 10 bis 100 nm (100 bis 1000 Å) beträgt.

0 066 675

FIG. 1.1

FIG. 1.2

FIG. 1.3

FIG. 1.4

1

FIG. 1.5

FIG. 1.6

FIG. 2

DEPRESSION